# NEUE EUROPÄISCHE PATENTSCHRIFT

(11) **EP 1 987 708 B2**
(45) Veröffentlichungstag und Bekanntmachung des Hinweises auf die Entscheidung über den Einspruch: **08.03.2017**
(45) Hinweis auf die Patenterteilung: 30.10.2013
(21) Anmeldenummer: 07721870.9
(22) Anmeldetag: 23.01.2007
(51) Int. Cl.: H05K 3/28, H05K 5/06

(54) **VERFAHREN ZUM VERGIESSEN ELEKTRISCHER UND/ODER ELEKTRONISCHER BAUTEILE IN EINEM GEHÄUSE**
METHOD FOR ENCAPSULATING ELECTRICAL AND/OR ELECTRONIC COMPONENTS IN A HOUSING
PROCÉDÉ PERMETTANT DE SCELLER DES PARTIES STRUCTURALES ÉLECTRIQUES ET / OU ÉLECTRONIQUES DANS UN BOÎTIER

(30) Priorität: 24.02.2006 DE 102006009120; 13.03.2006 DE 102006011757
(43) Veröffentlichungstag der Anmeldung: 05.11.2008
(73) Patentinhaber: Kraus, Hilmar, 60320 Frankfurt am Main (DE)
(72) Erfinder: Kraus, Hilmar, 60320 Frankfurt am Main (DE)
(74) Vertreter: Patent- und Rechtsanwälte Ullrich & Naumann
(86) Internationale Anmeldenummer: PCT/DE2007/000147
(87) Internationale Veröffentlichungsnummer: WO 2007/095880

(56) Entgegenhaltungen:
- DE-A1- 1 912 635
- DE-A1- 2 348 903
- DE-A1- 4 407 782
- DE-A1- 4 407 782
- DE-A1- 4 430 762
- DE-A1- 10 047 644
- DE-A1- 10 130 517
- DE-B- 1 136 100
- DE-C- 892 974
- DE-C2- 4 407 782
- DE-U1- 20 113 973
- DE-U1- 29 503 403
- GB-A- 859 006
- GB-A- 1 143 854
- JP-A- 9 046 072
- US-A- 3 748 538
- US-A- 5 699 231
- US-A- 6 046 076
- US-A1- 2004 180 472
- Handouts: Lehrgang "Epoxidharze in der Elektrotechnik"
- DROSDOWSKI G. ET AL: 'DUDEN Fremdwörterbuch', Bd. 5, 1990, DUDENVERLAG, MANNHEIM - LEIPZIG - WIEN - ZÜRICH Seiten 230 - 231

## Beschreibung

Die Erfindung betrifft ein Verfahren zum Vergießen elektrischer und/oder elektronischer Bauteile in einem Gehäuse, wobei die Bauteile auf einer Leiterplatte in einer Baugruppe angeordnet sind, wobei die Baugruppe in dem Gehäuse positioniert und mit einem aushärtenden, elektrisch isolierenden Vergussmaterial vergossen wird und wobei der Verguss in einer Gießkammer unter einem Druck unterhalb des atmosphärischen Drucks stattfindet.

Das hier in Rede stehende Verfahren lässt sich zur Herstellung beliebiger elektrischer/elektronischer Baugruppen in einem Gehäuse nutzen. Dabei kann es sich beispielsweise um Netzteile bzw. Netzteilmodule handeln, die eine Resistenz gegen Umwelteinflüsse wie Betauchung und Verschmutzung, Schock, Vibration, etc. aufzuweisen haben. Jedoch sei an dieser Stelle betont, dass es sich hier um jedwede elektrische und/oder elektronische Bauteile bzw. Baugruppen in einem Gehäuse handeln kann, wobei durch den Verguss nicht nur eine Abdichtung gegenüber der Umgebung, sondern insbesondere auch eine elektrische Isolation innerhalb der Baugruppe stattfindet. Unter Zugrundelegung eines entsprechenden Vergusses ist es möglich, die elektrischen und/oder elektronischen Bauteile möglichst eng zueinander auf der Leiterplatte bzw. Leiterbahn anzuordnen, wodurch eine weiter-reichende Miniaturisierung entsprechender Baugruppen möglich ist.

Aus der Praxis ist das eingangs genannte Verfahren bereits hinlänglich bekannt, wobei dieses Verfahren bei atmosphärischem Druck angewandt wird. Dabei ist nicht auszuschließen, dass der Verguss Luftblasen enthält, so dass eine allumfassende elektrische Isolation der einzelnen Bauteile nicht gewährleistet ist. Außerdem gelangt das Vergussmaterial nur bedingt an alle Bauteile, so dass auch insoweit eine zufrieden stellende Einbettung und Isolation der Bauteile nicht gewährleistet sein kann.

Außerdem neigen Elektrolytkondensatoren bei Betrieb und Wärmeeinwirkung zum Ausgasen. Sind solche Elektrolytkondensatoren nicht insgesamt umgossen oder von Luftblasen umgeben, so kann eine Beschädigung der Baugruppe und somit ein Defekt in der Funktion auftreten.

Die Druckschrift DE 100 47 644 A1 beschreibt ein Verfahren zum Vergießen elektrischer Bauteile in einem Gehäuse. Die Bauteile sind dabei auf einer Leiterplatte in einer Baugruppe angeordnet. Die Baugruppe ist in einem Gehäuse positioniert und mit einem aushärtenden, elektrisch isolierenden Vergussmaterial mittels Vakuumbefüllung vergossen.

Die Druckschrift DE 1 136 100 B zeigt eine Anlage zum Aufbereiten und Vergießen von Gießharz unter Vakuum.

Die Druckschrift JP 9 046072 A beschreibt eine bei atmosphärischem Druck vergossene Baugruppe aus elektrischen und/oder elektronischen Bauteilen in einem Gehäuse.

Der vorliegenden Erfindung liegt die Aufgabe zugrunde, ein Verfahren der gattungsbildenden Art derart auszugestalten und weiterzubilden, dass die zuvor genannten Probleme nicht oder allenfalls in äußerst reduziertem Umfange auftreten. Die Bildung von Luftblasen im Vergussmaterial ist weitestgehend verhindert.

Die zuvor aufgezeigte Aufgabe ist durch ein Verfahren mit den Merkmalen des Patentanspruchs 1 gelöst. Danach ist das gattungsbildende Verfahren dadurch gekennzeichnet, dass die Baugruppe vor dem Vergießen mit Strömungspfaden bzw. Strömungskanälen für das Vergussmaterial versehen wird, dass die Strömungspfade bzw. Strömungskanäle in Form von eine gelochte Leiterplatte bildende Bohrungen ausgeführt sind und dass der Unterdruck nach dem Vergießen und vor dem Aushärten in Etappen, bis hin zur vollständigen Aufhebung des Unterdrucks, aufgehoben wird.

Erfindungsgemäß ist erkannt worden, dass die zuvor genannten Probleme dann weitestgehend beseitigt sind, wenn der Verguss unter einem Druck unterhalb des atmosphärischen Drucks stattfindet. Dazu kann der Verguss in einer evakuierbaren Gießkammer erfolgen. Nach dem Vergießen mit Vergussmaterial wird der Unterdruck aufgehoben, so dass das Vergussmaterial regelrecht in die evakuierten Zwischenräume zwischen den elektrischen und/oder elektronischen Bauteilen im Gehäuse hineingesogen wird. Die Bildung von Luftblasen im Vergussmaterial ist dadurch weitestgehend verhindert. Außerdem lässt sich durch das zuvor genannte erfindungsgemäße Verfahren gewährleisten, dass die elektrischen und/oder elektronischen Bauteile insgesamt durch das Vergussmaterial umgeben sind, wodurch sich eine unmittelbare elektrische Isolation der einzelnen Bauteile ergibt. Somit lassen sich die Bauteile näher aneinander anordnen, nämlich aufgrund der besonderen elektrischen Isolation zwischen den Bauteilen durch die Vergussmasse. Enge Packungsdichten und Schichtungen von Leiterplatten sind denkbar.

Des Weiteren wird die Baugruppe vor dem Vergießen mit Strömungspfaden bzw. Strömungskanälen für das Vergussmaterial versehen. Diese Strömungspfade oder Strömungskanäle sollen gewährleisten, dass das Vergussmaterial überall hin gelangen kann, und zwar von der offenen Seite des Gehäuses her auch in Bereiche zwischen der Innenwandung des Gehäuses und den Bauteilen bzw. der Baugruppe.

Die Strömungspfade bzw. Strömungskanäle sind in Form von Durchgängen bzw. Bohrungen in der Leiterplatte/Leiterbahn ausgeführt, wobei diese Durchgänge überall dort vorzusehen sind, wo es die Anordnung der elektrischen und/oder elektronischen Bauteile erlaubt und insbesondere dort, wo das Vergussmaterial sonst nur schwer oder gar nicht hinströmen kann. Letztendlich ist es denkbar, dass die Leiterplatte regelrecht gelocht wird, nämlich überall dort, wo die Lochung die Stromführung nicht behindert und insbesondere dort, wo Bauteile angeordnet sind, die es in besonderem Maße zu umgießen bzw. zu isolieren gilt.

Erfindungsgemäß wird der Unterdruck nach dem Vergießen und vor dem Aushärten in Etappen, bis hin zur vollständigen Aufhebung des Unterdrucks, aufgehoben.

In Bezug auf eine besonders gute Haftung der Vergussmasse einerseits an den elektrischen und/oder elektronischen Bauteilen und andererseits an dem Gehäuse ist es von weiterreichendem Vorteil, wenn die Baugruppe - möglichst gemeinsam mit dem Gehäuse - vor dem Vergießen erwärmt, insbesondere getrocknet wird. Die dazu erforderliche Temperaturbehandlung kann im Bereich zwischen 50° C bis etwa 80° C, vorzugsweise bei etwa 70° C, stattfinden. Außerdem ist es von Vorteil, wenn diese Temperaturbehandlung über einen Zeitraum hinweg von 20 bis 40 min, vorzugsweise über 30 min hinweg, stattfindet. Die Temperaturbehandlung findet in vorteilhafter Weise in einem Trocknungsschrank statt, von wo aus die in das Gehäuse eingesetzten Baugruppen gemeinsam mit dem Gehäuse in eine Gießkammer verbracht werden. Ebenso ist es denkbar, dass es sich bei der Gießkammer um eine temperierte Gießkammer handelt, die gleichzeitig als Trocknungsschrank dient.

In weiter vorteilhafter Weise wird die Baugruppe vor dem Vergießen auf eine Vergusstemperatur verbracht, wobei davon auszugehen ist, dass die zuvor der Temperaturbehandlung unterzogene Baugruppe abgekühlt wird oder aufgrund der Umgebungstemperatur von alleine abkühlt. Das Vergießen des Vergussmaterials erfolgt bei einer Vergusstemperatur von etwa 30° C bis 40° C. In besonders vorteil-hafter Weise haben beim Vergießen die Baugruppe nebst Gehäuse und das Vergussmaterial in etwa die gleiche Temperatur. Außerdem sollte gewährleistet sein, dass sich zwischen dem Vergussmaterial und der Baugruppe bzw. dem Gehäuse geringe Oberflächenspannungen einstellen, so dass mit hinreichend guter Adhäsion im abgekühlten Zustand zu rechnen ist.

In weiter vorteilhafter Weise sollte ein Vergussmaterial mit hoher Wärmeleitfähigkeit verwendet werden, so dass im Betrieb der Baugruppe, d.h. im vergossenen Zustand, eine hinreichend gute Wärmeabfuhr an die Oberfläche einerseits des Gehäuses und andererseits zur freien Oberfläche hin gewährleistet ist. Auch ist es denkbar, dass das Gehäuse mit Wärmetauscherelementen versehen bzw. ausgestattet ist. Diese können integrale Bestandteile des Gehäuses sein.

Als Vergussmasse kommen beliebige geeignete Materialien in Frage, beispielsweise ein zweikomponentiges Gießharz. Die Komponenten des Gießharzes werden vor dem Vergießen möglichst homogen gemischt. Ein kontinuierliches Mischen ist insbesondere bei automatischer oder zumindest halbautomatischer Fertigung möglich oder denkbar, wobei das Gemisch vorzugsweise über ein Mischrohr und gegebenenfalls ein Gießventil zum Vergießen bereitgestellt wird. Über einen Prozessrechner lässt sich das Mischungsverhältnis der Komponenten und/oder die jeweils erforderliche Dosiermenge am Gießharz vorgeben, und zwar je nach der pro Einheit erforderlichen Menge an Vergussmaterial.

Wie bereits zuvor erwähnt, sollte das Vergussmaterial vor dem Vergießen oder beim Vergießen auf eine geeignete Temperatur erhitzt werden, wobei sich hier eine Prozesstemperatur von etwas 30° C bis etwa 40° C als vorteilhaft erweist.

In besonders raffinierter Weise ist es von weiterem Vorteil, wenn das Vergussmaterial bei zumindest leicht gekipptem Gehäuse in dieses vergossen wird. Durch diese einfache Maßnahme lässt sich das Hinterströmen und Umströmen der gesamten Baugruppe durch Vergussmaterial begünstigen. So bietet es sich an, das Gehäuse zum Vergießen um etwa 5° bis 15°, vorzugsweise um 6° bis 10°, zu kippen.

In Bezug auf einen insgesamt abdichtenden und dabei homogenen Verguss ist es von Vorteil, wenn nach dem Vergießen einer ersten Füllmenge zunächst einmal abgewartet wird, bis sich die Vergussmasse hinreichend gut im Gehäuse um die Bauteile der Baugruppe herum verteilt hat. Insbesondere bei gekipptem Gehäuse könnte dieses bis zum tiefstgelegenen oberen Rand des Gehäuses vergossen werden, wobei es denkbar ist, dass Vergussmasse beim Aushärten zumindest geringfügig schrumpft. Ein nachträgliches abermaliges Vergießen ist dann erforderlich und von Vorteil.

Bereits zuvor ist erwähnt worden, dass der Verguss unter einem Druck unterhalb des atmosphärischen Drucks stattfindet. Erfindungsgemäß ist der Verguss in einer Vakuumkammer bei einem Unterdruck von etwa 0,9 bar bis 0,8 bar vorzunehmen. So wird das Vergussmaterial bei Unterdruck in das Gehäuse gegossen, wobei die gesamte Baugruppe in das Gehäuse gestellt ist. Nach dem Vergießen wird die Vakuumkammer belüftet, so dass das Vergussmaterial regelrecht in das Gehäuse hineingesaugt wird, nämlich aufgrund des dort herrschenden Unterdrucks. Dies begünstigt das Vergießen mit Vergussmaterial erheblich und vermeidet die Bildung von Bläschen während des Vergusses bzw. kurzzeitig danach.

Die Belüftung der Vakuumkamme erfolgt in Etappen bis hin zur vollständigen Aufhebung des Unterdrucks. Es sollte auf die Zähflüssigkeit bzw. Viskosität des Vergussmaterials abgestellt werden.

Ein nächster Schritt ist denkbar, wonach das Gehäuse vorzugsweise in einem Wärmeschrank zumindest weitgehend waagerecht positioniert wird. Dort oder bereits unmittelbar nach dem ersten Vergießen bzw. nach dem ersten Verguss kann eine weitere Menge an Vergussmasse nachgegossen werden. Diese weitere Menge an Vergussmasse sollte bis unter die obere Kante des Gehäuses, vorzugsweise bis etwa 1 mm unter die obere Kante vergossen werden. An dieser Stelle sei angemerkt, dass auch ein einmaliges Vergießen denkbar ist, wobei dazu eine waagerechte Position des Gehäuses beim Vergießen realisiert sein sollte.

Anschließend wird das vergossene Gießharz bei einer Umgebungstemperatur von etwas 50° C bis 80° C, vorzugsweise bei etwa 70° C, ausgehärtet. Die Aushärtung erfolgt in weiter vorteilhafter Weise in einem Wärmeschrank, wobei die Vakuumkammer gleichzeitig auch als Wärmeschrank ausgebildet sein kann.

Insbesondere bei Vorkehrung eines separaten Wärmeschranks bietet es sich an, eine hinreichend lange Temperaturbehandlung für das Aushärten vorzusehen, nämlich über eine Zeitdauer von etwa 3 bis 5 Stunden, vorzugsweise über 4 Stunden hinweg. Findet das Aushärten bei Raumtemperatur statt, so ist eine Aushärtezeit von bis zu 12 Stunden oder sogar mehr erforderlich.

Nach dem zuvor beschriebenen Aushärten kann ein weiteres Verfüllen des Gehäuses mit Vergussmasse erfolgen, wodurch sich ein sogenannter Spiegelverguss mit bündig abschließender Oberfläche, nämlich bis zur Gehäuseoberkante, erzielen lässt. Der Spiegelverguss sollte eine möglichst geringe Dicke haben, beispielsweise von maximal 1 mm, um nämlich ein abermaliges Schrumpfen des Vergussmaterials zu vermeiden.

Eine abschließende Härtung wird im Bereich von 24 Stunden bis 72 Stunden, insbesondere im Bereich von etwa 48 Stunden, durchgeführt. Das abschließende Aushärten kann bei Raumtemperatur oder geringer Temperierung erfolgen, so dass eine hinreichend gute Haftung der Vergussmasse gegenüber der Innenwandung des Gehäuses und auch gegenüber den Bauteilen gegeben ist.

## Patentansprüche

1. Verfahren zum Vergießen elektrischer und/oder elektronischer Bauteile in einem Gehäuse, wobei die Bauteile auf einer Leiterplatte in einer Baugruppe angeordnet sind, wobei die Baugruppe in dem Gehäuse positioniert und mit einem aushärtenden, elektrisch isolierenden Vergussmaterial vergossen wird und wobei der Verguss in einer Vakuumkammer als Gießkammer unter einem Druck unterhalb des atmosphärischen Drucks stattfindet,
**dadurch gekennzeichnet, dass** die Baugruppe vor dem Vergießen mit Strömungspfaden bzw. Strömungskanälen für das Vergussmaterial versehen wird, dass die Strömungspfade bzw. Strömungskanäle in Form von eine gelochte Leiterplatte bildende Bohrungen ausgeführt sind, dass der Verguss in der Vakuumkammer bei einem Unterdruck von etwa 0,9 bar bis 0,8 bar erfolgt, und dass der Unterdruck nach dem Vergießen und vor dem Aushärten in Etappen, bis hin zur vollständigen Aufhebung des Unterdrucks, aufgehoben wird.

2. Verfahren nach Anspruch 1, **dadurch gekennzeichnet, dass** die Baugruppe vor dem Vergießen erwärmt, insbesondere getrocknet wird.

3. Verfahren nach Anspruch 2, **dadurch gekennzeichnet, dass** die Temperaturbehandlung bei 50°C bis etwa 80°C, vorzugsweise bei 70°C, erfolgt.

4. Verfahren nach Anspruch 2 oder 3, **dadurch gekennzeichnet, dass** die Temperaturbehandlung über einen Zeitraum von 20 bis 40 Minuten, vorzugsweise über 30 Minuten, erfolgt.

5. Verfahren nach einem der Ansprüche 1 bis 4, **dadurch gekennzeichnet, dass** die Baugruppe vor dem Vergießen auf eine Vergusstemperatur verbracht, vorzugsweise abgekühlt.

6. Verfahren nach einem der Ansprüche 1 bis 5, **dadurch gekennzeichnet, dass** das Vergießen des Vergussmaterials bei einer Vergusstemperatur von etwa 30°C bis 40°C erfolgt, wobei beim Vergießen die Baugruppe nebst Gehäuse und das Vergussmaterial in etwa die gleiche Temperatur haben.

7. Verfahren nach einem der Ansprüche 1 bis 6, **dadurch gekennzeichnet, dass** als Vergussmasse ein zweikomponentiges Gießharz verwendet wird, wobei die Komponenten des Gießharzes vor dem Vergießen homogen gemischt werden.

8. Verfahren nach Anspruch 7, **dadurch gekennzeichnet, dass** über einen Prozessrechner das Mischungsverhältnis der Komponenten und die jeweils erforderliche Dosiermenge an Gießharz vorgegeben werden.

9. Verfahren nach einem der Ansprüche 1 bis 8, **dadurch gekennzeichnet, dass** das Vergussmaterial bei zumindest leicht gekipptem Gehäuse in dieses vergossen wird, wobei das Gehäuse zum Vergießen um etwa 5° bis 15°, vorzugsweise um 6° bis 10°, gekippt wird.

10. Verfahren nach einem der Ansprüche 1 bis 9, **dadurch gekennzeichnet, dass** nach dem Vergießen einer ersten Fülimenge abgewartet wird, bis sich die Vergussmasse hinreichend gut im Gehäuse um die Bauteile der Baugruppe herum verteilt hat.

11. Verfahren nach einem der Ansprüche 1 bis 10, **dadurch gekennzeichnet, dass** das Gehäuse vorzugsweise in einem Wärmeschrank zumindest weitgehend waagerecht positioniert wird und dass nach dem ersten Verguss eine weitere Menge an Vergussmasse nachgegossen wird, wobei die weitere Menge an Vergussmasse bis unter die obere Kante des Gehäuses, vorzugsweise bis etwa 1 mm unter die obere Kante, vergossen wird.

12. Verfahren nach einem der Ansprüche 1 bis 11, **dadurch gekennzeichnet, dass** das vergossene Gießharz bei einer Umgebungstemperatur von etwa 50°C bis 80°C, vorzugsweise bei etwa 70°C, aushärtet, wobei die Temperaturbehandlung für das Aushärten über eine Zeitdauer von etwa drei bis zwölf Stunden, vorzugsweise über vier bis fünf Stunden, erfolgt.

13. Verfahren nach einem der Ansprüche 1 bis 12, **dadurch gekennzeichnet, dass** nach dem Aushärten ein weiteres Verfüllen des Gehäuses mit Vergussmasse als sog. Spiegelverguss bis zur Gehäuseoberkante erfolgt.

14. Verfahren nach einem der Ansprüche 1 bis 13, **dadurch gekennzeichnet, dass** ein Vergussmaterial mit hoher Wärmeleitfähigkeit verwendet wird.

## Claims

1. Method for encapsulating electrical and/or electronic components in a housing, wherein the components are arranged on a printed circuit board in an assembly group, wherein the assembly group is positioned in the housing and encapsulated with a curing, electrically insulating encapsulating material, and wherein the encapsulation takes place in a vacuum chamber as casting chamber under a pressure below atmospheric pressure,
**characterised in that** the assembly group is provided with flow paths or flow channels for the encapsulating material prior to the encapsulation, **in that** the flow paths or flow channels are in the form of bores forming a perforated printed circuit board, **in that** the encapsulation takes place in the vacuum chamber at a low pressure of approximately from 0.9 bar to 0.8 bar, and **in that**, after the encapsulation and before curing, the low pressure is increased in steps until the low pressure is removed completely.

2. Method according to claim 1, **characterised in that** the assembly group is heated, in particular dried, prior to the encapsulation.

3. Method according to claim 2, **characterised in that** the heat treatment takes place at from 50°C to approximately 80°C, preferably at 70°C.

4. Method according to claim 2 or 3, **characterised in that** the heat treatment takes place over a period of from 20 to 40 minutes, preferably over a period of 30 minutes.

5. Method according to any one of claims 1 to 4, **characterised in that** the assembly group is brought to an encapsulation temperature, preferably cooled, prior to the encapsulation.

6. Method according to any one of claims 1 to 5, **characterised in that** the encapsulation with the encapsulating material takes place at an encapsulation temperature of approximately from 30°C to 40°C, wherein during the encapsulation the assembly group, together with the housing, and the encapsulating material have approximately the same temperature.

7. Method according to any one of claims 1 to 6, **characterised in that** there is used as the encapsulating material a two-component casting resin, wherein the components of the casting resin are mixed homogeneously prior to the encapsulation.

8. Method according to claim 7, **characterised in that** the mixing ratio of the components and the metering quantity of casting resin required in a particular case are given by a process computer.

9. Method according to any one of claims 1 to 8, **characterised in that** the encapsulating material is poured into the housing with the housing tilted at least slightly, wherein the housing is tilted, for pouring, by approximately from 5° to 15°, preferably by from 6° to 10°.

10. Method according to any one of claims 1 to 9, **characterised in that**, after the pouring of a first filling quantity, a waiting period is observed until the encapsulating compound has distributed itself sufficiently well in the housing around the components of the assembly group.

11. Method according to any one of claims 1 to 10, **characterised in that** the housing is preferably positioned at least largely horizontally in a heating cabinet, and **in that**, after the first pouring, a further quantity of encapsulating compound is poured in, wherein the further quantity of encapsulating compound is poured in to below the upper edge of the housing, preferably to approximately 1 mm below the upper edge.

12. Method according to any one of claims 1 to 11, **characterised in that** the poured casting resin cures at an ambient temperature of approximately from 50°C to 80°C, preferably at approximately 70°C, wherein the heat treatment for curing takes place over a period of approximately from three to twelve hours, preferably over a period of from four to five hours.

13. Method according to any one of claims 1 to 12, **characterised in that**, after curing, a further filling of the housing with encapsulating compound as a so-called full encapsulation to the upper edge of the housing takes place.

14. Method according to any one of claims 1 to 13, **characterised in that** an encapsulating material with high thermal conductivity is used.

## Revendications

1. Procédé permettant d'encapsuler des composants électriques et/ou électroniques dans un boîtier, lesdits composants étant disposés sur une plaquette de circuits imprimés dans un module, ledit module étant positionné dans le boîtier et étant enrobé par un matériau durcissant électroisolant, et l'enrobage se produisant dans une chambre sous vide en tant que chambre de coulée sous une pression inférieure à la pression atmosphérique,
**caractérisé en ce que** dans le module sont réalisés, avant l'enrobage, des voies d'écoulement ou des canaux d'écoulement pour le matériau d'encapsulage, **en ce que** les voies d'écoulement ou canaux d'écoulement sont réalisés sous forme de forrures formant une plaquette de circuits imprimés perforée, **en ce que** le matériau en fusion est coulé dans la chambre sous vide en présence d'une dépression de 0,9 bar à 0,8 bar environ, et **en ce que** la dépression est supprimée après l'enrobage et avant le durcissement en étapes jusqu'à la suppression totale de la dépression.

2. Procédé selon la revendication 1, **caractérisé en ce que** le module est chauffé, en particulier séché avant l'enrobage.

3. Procédé selon la revendication 2, **caractérisé en ce que** le traitement thermique est effectué autour de 50°C jusqu'à environ 80°C, de préférence à 70°C.

4. Procédé selon la revendication 2 ou 3, **caractérisé en ce que** le traitement thermique est effectué pendant un laps de temps de 20 à 40 minutes, de préférence supérieur à 30 minutes.

5. Procédé selon l'une quelconque des revendications 1 à 4, **caractérisé en ce que**, avant l'enrobage, le module est amené à la température d'enrobage, de préférence il est refroidi.

6. Procédé selon l'une quelconque des revendications 1 à 5, **caractérisé en ce que** le matériau d'encapsulage est mis en fusion à une température d'environ 30°C à 40°C, le module, y compris le boîtier et le matériau d'encapsulage, ayant sensiblement la même température lors du processus d'encapsulage.

7. Procédé selon l'une quelconque des revendications 1 à 6, **caractérisé en ce que** le matériau d'encapsulage utilisé est une résine à sceller à deux composants, les composants de ladite résine à sceller étant mélangés de manière homogène avant l'encapsulage.

8. Procédé selon la revendication 7, **caractérisé en ce que** le rapport de mélange des composants et la quantité de résine à sceller nécessaire sont prédéfinis par un ordinateur du processus.

9. Procédé selon l'une quelconque des revendications 1 à 8, **caractérisé en ce que** le matériau d'encapsulage est coulé dans le boîtier lorsque celui-ci est au moins légèrement incliné, le boîtier étant incliné pour le processus d'encapsulage de 5° à 15° environ, de préférence de 6° à 10°.

10. Procédé selon l'une quelconque des revendications 1 à 9, **caractérisé en ce qu'**après le remplissage avec une première quantité de remplissage est prévu un temps d'attente jusqu'à ce que le matériau d'encapsulage se soit suffisamment réparti dans le boîtier tout autour des composants du module.

11. Procédé selon l'une quelconque des revendications 1 à 10, **caractérisé en ce que** le boîtier est positionné au moins en grande partie horizontalement, de préférence dans une armoire de chauffage, et **en ce qu'**après le premier processus de remplissage, une autre quantité de matériau d'encapsulage est ajoutée, la quantité supplémentaire de matériau d'encapsulage étant versée jusqu'en dessous du bord supérieur du boîtier, de préférence jusqu'à environ 1 mm en dessous du bord supérieur.

12. Procédé selon l'une quelconque des revendications 1 à 11, **caractérisé en ce que** la résine à sceller coulée durcit à une température ambiante de 50°C à 80°C environ, de préférence de 70°C, le traitement thermique pour le durcissement étant effectué pendant un laps de temps d'environ trois à douze heures, de préférence plus de quatre à cinq heures.

13. Procédé selon l'une quelconque des revendications 1 à 12, **caractérisé en ce qu'**après le durcissement, le boîtier continue à être rempli jusqu'au bord supérieur du boîtier avec le matériau d'encapsulage en formant un enrobage à ras bord.

14. Procédé selon l'une quelconque des revendications 1 à 13, **caractérisé en ce que** l'on utilise un matériau d'encapsulage à conductivité thermique élevée.
